# EUROPEAN PATENT SPECIFICATION

(11) **EP 2 869 305 B1**
(45) Date of publication and mention of the grant of the patent: **02.10.2019**
(21) Application number: 14158410.2
(22) Date of filing: 07.03.2014
(51) Int. Cl.: G11C 27/02, H03K 5/24

(54) **Bipolar isolated high voltage sampling network**
Bipolares isoliertes Hochspannungsabtastungsnetzwerk
Réseau d'échantillonnage de haute tension isolée bipolaire

(30) Priority: 29.10.2013 US 201361897067 P; 16.01.2014 US 201414157316
(43) Date of publication of application: 06.05.2015
(73) Proprietor: Linear Technology Corporation, Milpitas, CA 95035 (US)
(72) Inventor: Trampitsch, Gerd, 85774 Unterfoehring (DE)
(74) Representative: Müller-Boré & Partner Patentanwälte PartG mbB

(56) References cited:
- EP-A1- 2 866 347
- EP-A2- 2 533 248
- US-A- 3 737 893
- US-A- 5 184 128
- US-B1- 6 232 907

## Description

### CROSS REFERENCE TO RELATED APPLICATIONS

The present application relates to and claims priority of U.S. provisional patent application ("Copending Provisional Application"), serial no. 61/897,067, entitled "Bipolar Isolated High Voltage Sampling Network," filed on October 29, 2013.

### BACKGROUND OF THE INVENTION

### 1. Field of the Invention

The present invention relates to isolated sampling of differential input signals. In particular, the present invention relates to isolated sampling of differential input signals in a sampling network, such as an input stage of an analog-to-digital converter (ADC).

### 2. Discussion of the Related Art

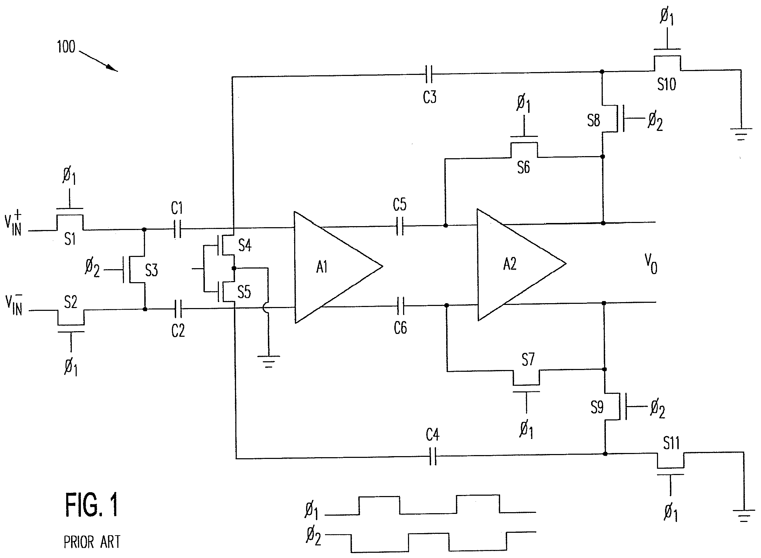

Figure 1 is a schematic diagram of a differential double-correlated sampling instrumentation amplifier (circuit 100) disclosed in the article ("the Yen article"), entitled "A MOS Switched-Capacitor Instrumentation Amplifier," by R.C. Yen and P.R. Gray, published in the IEEE Journal of Solid State Circuits, pp. 1008-13, December, 1982. As shown in Figure 1, circuit 100 of Figure 1 shorts the input terminals V_{IN}⁺ and V_{IN}⁻ with switch S3 that is controlled by a signal φ₂. Signal φ₂ is a logic signal that swings within the power supply voltages. As circuit 100 does not use charge pumps for controlling the input sampling network, circuit 100 is unable to sample far outside of the power supply voltages.

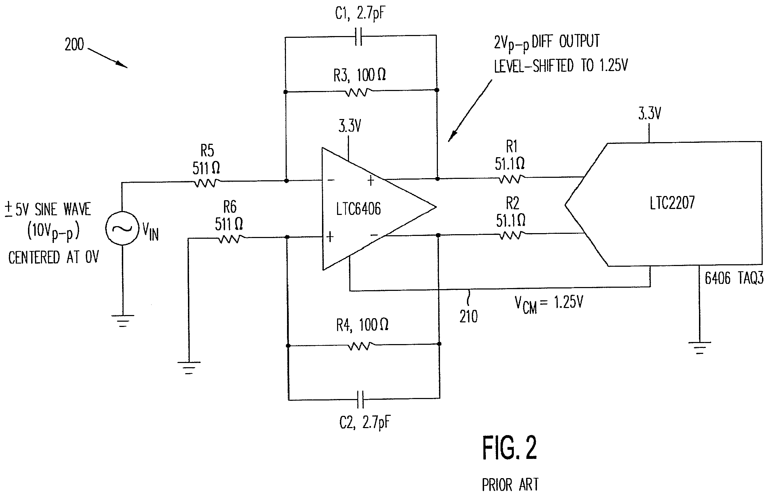

Figure 2 shows a prior art ADC driver circuit that receives a single-ended input signal to provide a differential signal for an ADC. As shown in Figure 2, the ADC driver circuit requires resistive dividers and an additional buffer amplifier to limit the differential voltage at the ADC input terminals to a voltage swing that is close to that of the ADC's supply voltages.

Prior art patent application document US 3,737,893 relates to bipolar analog input signals which are tested for apparent polarity, and depending on the polarity indication, the analog signal is either inverted or not inverted and resulting input signal is combined with a constant reference voltage so that the effective input to the analog-to-digital convert will always be a unipolar voltage having a minimum nominal value greater than the potential error of the polarity decision element.

Prior art patent application document US 5,184,128 relates to an integrating type A/D converter having a set of analog switches and a control logic unit for selectively connecting a pair of input terminals for an unknown analog input voltage signal with a pair of input leads across a buffer and integrator in order to apply, first in an integrate phase, the analog input signal in a polarity direction that causes the integrator to ramp up in the same direction regardless of the polarity of the analog input signal, and then in a deintegrate phase, reference voltages are applied across the input leads in a fixed direction opposite to the applied input voltage such that a zero crossing signal is output by the comparator.

Prior art patent document US 6,232,907 B1 relates to an A/D converter which includes a sample-and-hold circuit having an input and an output, a zero-crossing detector having an input coupled to an output of the sample-and-hold circuit and having an output indicative of a change in polarity of an input signal thereto and a polarity reverser having an input coupled to the output of the sample-and-hold circuit, a control terminal coupled to an under control of the output of the zero-crossing detector and an output terminal.

European patent application document EP 2 866 347 A1 falling within the terms of Art. 54(3) EPC relates to a bootstrapped switch circuit capable of operating at input signals from far below the negative supply rail to far beyond the positive supply rail and may include (a) a switch S1 having a first terminal coupled to an input terminal, a second terminal coupled to an output terminal, and a control terminal; (b) a charge pump CP coupled to one or more clock signals PHI1, PHI2, and isolated from a timing circuit 102 via a first capacitor and a second capacitor, the charge pump generating an output voltage; and (c) a logic circuit 101 coupled to one or more clock signals and isolated from the timing control circuit via a third capacitor and a fourth capacitor, wherein the logic circuit provides a control signal to the control terminal of the switch that is derived from the output voltage of the charge pump.

Thus, according to an aspect, the problem relates to providing a sampling network which has improved noise and increased linearity, has lower power consumption, and allows sampling of signals beyond the power supply voltage.

### Summary

This problem is solved by a bipolar input sampling network and a method of providing such a network having the features disclosed in claims 1 and 9. Preferred embodiments are defined in the dependent claims.

The method and the network achieve fully isolated sampling of bipolar differential voltage signals. The isolated sampling network is suitable for applications in which sampling signals far outside of the supply voltages is desired. A sampling network of the present invention samples a differential signal between voltages -V_{DSMAX} and V_{DSMAX}, even with common mode voltages that exceed the supply voltage (e.g., an input stage of an ADC). The bipolar isolated input sampling network includes a polarity comparator and sampling switches that operate as rectifiers. Rectification ensures that a unipolar sampling network needs only to sample signals of predetermined voltage levels. A sampling network of the present invention samples a differential signal between voltages -V_{DSMAX} and V_{DSMAX}, even with common mode voltages that exceed the supply voltage. In one implementation, an ADC with a maximum supply voltage of 3V is able to sample differential signals of ±3V or more at a common mode voltage of 10V.

A bipolar isolated sampling network of the present invention samples a differential input signal having a voltage swing between minus V_{DSMAX} to plus V_{DSMAX}. Such a sampling network (i) has better noise and increased linearity, as no resistive divider or buffer amplifier is needed, (ii) has lower power consumption and less aging and drift, due to its shorter analog signal processing chain, and (iii) allows sampling of signals far beyond the power supply voltage. In one embodiment, the source terminals of the sampling switches are connected to low impedance points, so that local charge pumps may be connected to control the gate voltage of the sampling switches relative to the potential at the source terminals of the sampling switches.

The present invention is better understood upon consideration of the detailed description below, in conjunction with the accompanying drawings.

### BRIEF DESCRIPTION OF THE DRAWINGS

Figure 1 is a schematic diagram of a differential double-correlated sampling instrumentation amplifier (circuit 100) disclosed in the prior art.
Figure 2 shows a prior art ADC driver that receives a single-ended input signal to provide a differential signal for an ADC.
Figure 3 shows isolated sampling network 600 disclosed in a copending patent
Figure 4 is a block diagram of differential isolated ADC input sampling network 400 that can accurately sample positive input voltages, which is controlled by complementary, but non-overlapping clock signals PHI1 and PHI2.
Figure 5 shows the waveforms of clock signals PHI1 and PHI2 of Figure 4.
Figure 6 is a block diagram of input sampling network 700 which includes rectifier circuit 701 that provides a positive differential signal to input sampling network 400, in accordance with one embodiment of the present invention.
Figure 7 is a block diagram of input sampling network 800 in which switched capacitor polarity comparator 803 detects signal polarity from the output differential signal of sampling circuit 400, in accordance with one embodiment of the present invention.

### DETAILED DESCRIPTION OF THE PREFERRED EMBODIMENTS

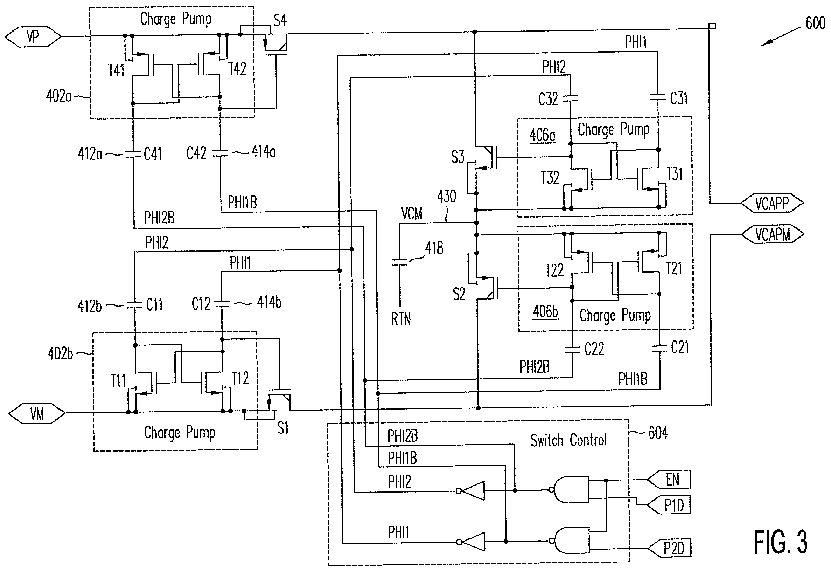

Figure 3 shows isolated sampling network 600 disclosed in US 8 907 703 B1.

Isolated sampling network 600 can sample differential signals from minus two diode drops up to two times the maximum drain-to-source voltage (V_{DSMAX}) for a given technology in which isolated sampling network 600 is implemented. As shown in Figure 3, PMOS device S4 samples positive input terminal VP and NMOS device S1 samples negative input terminal VM. Body diodes of PMOS device S4 and NMOS device S1 turn on when the differential input voltage across positive input terminal VP and negative input terminal VM reaches minus two diode drops, thereby constraining the negative differential voltage that can be sampled to minus two diode drops.

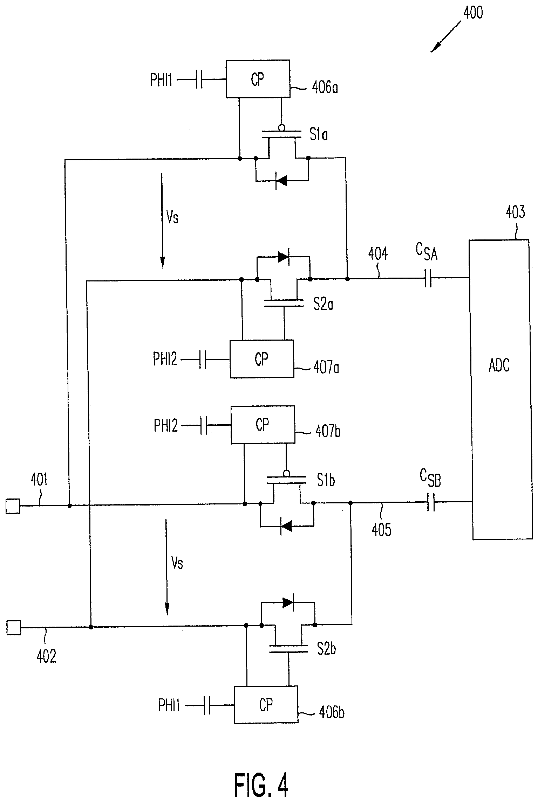

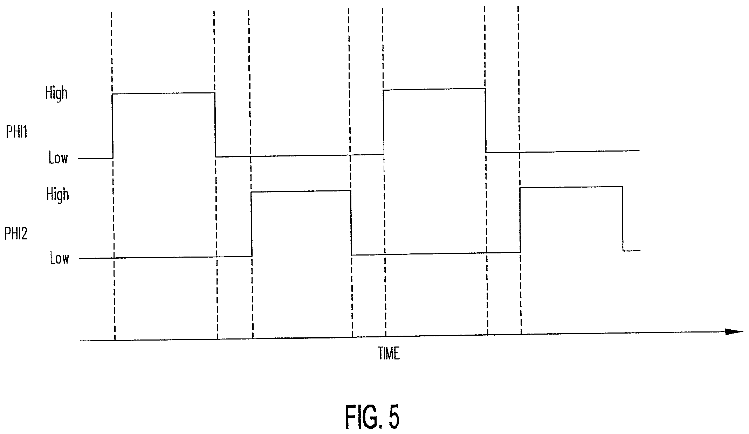

Figure 4 is a block diagram of differential isolated ADC input sampling network 400 that can accurately sample positive input voltages, which is controlled by complementary, but non-overlapping clock signals PHI1 and PHI2. The waveforms of clock signals PHI1 and PHI2 are shown in Figure 5. As shown in Figure 4, input sampling network 400 includes charge pump circuits 406a, 406b, 407a and 407b, switches S1a, S1b, S2a and S2b, and input sampling capacitors C_{SA} and C_{SB} of ADC 403. Clock signal PHIlb is the inverted signal of clock signal PHI1. Clock signal PHI2b is the inverted signal of clock signal PHI2. (Inverted signals are applied to charge pumps connected to PMOS switches because a negative gate-to-source voltage causes an PMOS switch to become conducting.) In sampling network 400, when clock signal PHI1 is at logic HIGH (i.e., "active"), switches S1a and S2b are conducting and switches S2a and S1b are non-conducting, so that differential signal Vs across input terminals 401 and 402 is presented at input terminals 404 and 405 of ADC 403. When clock signal PHI2 is active, switches S2a and S1b are conducting and switches S1a and S2b are non-conducting, so that differential signal Vs across input terminals 401 and 402 is presented in opposite polarity (i.e., -Vs) to input terminals 404 and 405 of ADC 403. Presenting the input signal in opposite polarities to ADC 403 allows offsets in the ADC circuit be canceled out, thereby enhancing accuracy. However, when input voltage Vs falls below minus one diode drop, the parasitic diodes of input sampling switches S1b and S2a at PHI1 active (or S2b and S1a at PHI2 active) become conductive, thereby causing significant sampling errors. Therefore, similar to isolated sampling network 600 of Figure 3, the input voltage range Vs across terminals 401 and 402 in sampling network 400 is limited from minus one diode drop to plus V_{DSMAX}. Charge pumps 406a, 406b, 407a and 407b may be implemented in the same manner as charge pumps 402a and 402b shown in Figure 3.

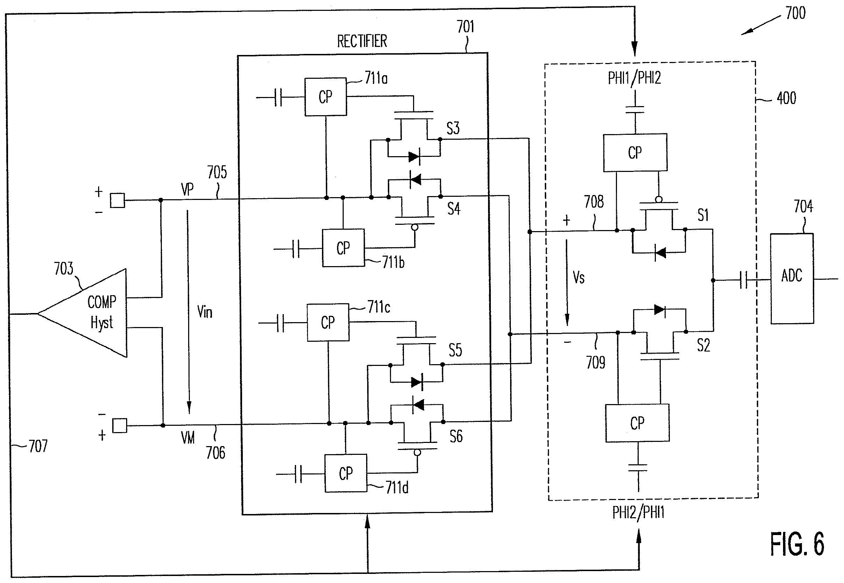

According to one embodiment of the present invention, the deficiency in input sampling network 400 is overcome by ensuring that it only receives positive input signals. Figure 6 is a block diagram of input sampling network 700 which includes rectifier circuit 701 that provides a positive differential signal to input sampling network 400, in accordance with one embodiment of the present invention. In Figure 6, input sampling circuit 400 is shown in single-ended form for brevity. However, it is understood that input sampling network 400 may be implemented in the differential input form shown in Figure 4. As shown in Figure 6, polarity comparator 703 determines the polarity of input differential signal Vᵢₙ across input terminals 705 and 706. Output signal 707 of polarity comparator 703, representing the polarity determination, selectively activates switch pairs S3 and S6 or S4 and S5 through charge pumps 711a through 711d. When input differential signal V_{IN} is positive, output signal 707 causes switches S3 and S6 to be conducting through the input signals to charge pumps 711a and 711d. When input differential signal V_{IN} is negative, output signal 707 causes switches S4 and S5 to be conducting through the input signals to charge pumps 711b and 711c. This results in a signal inversion which would cause the ADC to sample the wrong signal polarity. The control signals to charge pumps 711a-711d may be implemented in combinational circuit by those of ordinary skill in the art. (This rectification results in a signal inversion which would cause ADC 704 to sample the wrong signal polarity.) Output signal 707 may be stored into a flip-flop or register to record a polarity of input differential signal V_{IN}, so as to allow proper restoration of polarity in the output value from ADC 704. Alternatively, the sampling phases of clock signals PHI1 and PHI2 at switches S1 (i.e., switches S1a and S2b of Figure 4) and S2 (i.e., switches S2a and S1b of Figure 4) must be exchanged to compensate for the signal inversion. Such an exchange may be implemented by multiplexers that exchanges clock signals PHI1 and PHI2. Since input signal Vs across terminals 708 and 709 may become slightly negative without causing sampling errors, polarity comparator 703 is preferably provided some hysteresis to prevent a signal that has a magnitude close to polarity comparator 703's threshold from causing too many signal inversions. Output signal 707 of polarity comparator 707 is sampled by the ADC sampling clock and therefore causes only signal inversions that are synchronous with the ADC sampling clock.

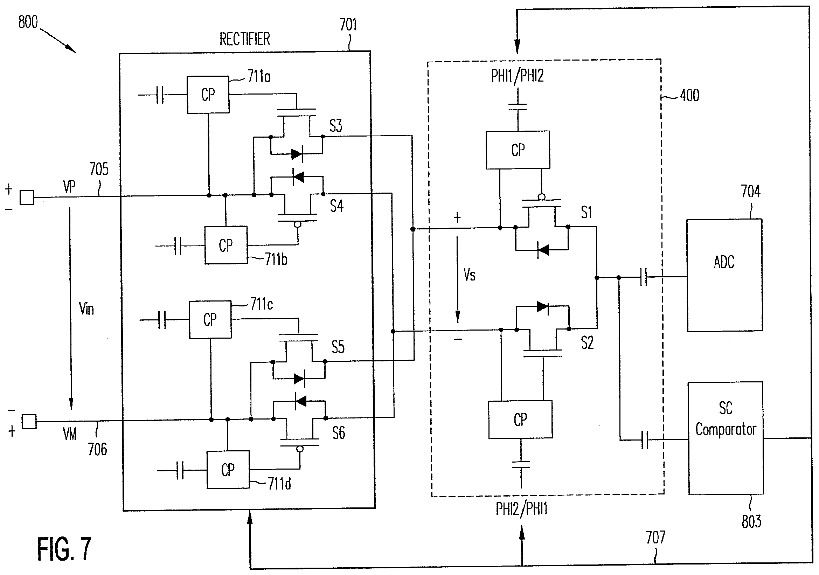

Figure 7 is a block diagram of input sampling network 800 in which switched capacitor polarity comparator 803 detects signal polarity from the output differential signal of sampling circuit 400 by reusing switches S1 and S2 as input switches, in accordance with one embodiment of the present invention.

Accordingly, a bipolar isolated input sampling network of the present invention is capable of sampling large bipolar differential signals using isolated sampling switches. The input range is significantly extended to between -V_{DSMAX} and V_{DSMAX}. Any signal inversion in the rectifier circuit may be compensated by changing the polarity sensitivity of subsequent blocks (e.g., by swapping clock signals PHI1 and PHI2 in isolated sampling network 400 of Figures 6 and 7) of the ADC.

The above detailed description is provided to illustrate specific embodiments of the present invention. The scope of protection of the present invention is defined in the accompanying claims.

## Claims

1. A bipolar input sampling network (700) configured to receive an input differential voltage signal (Vin) and configured to provide a sampled differential voltage signal, comprising:
a polarity comparator (703) that is configured to determine a polarity of the input differential voltage signal (Vin);
a capacitor-isolated rectifier circuit (701) configured to provide a rectified input differential voltage signal based on the polarity determined at the polarity comparator; and
a capacitor-isolated input sampling network (400, 704) configured to receive the rectified input differential voltage signal to provide the sampled differential voltage signal, wherein
the capacitor-isolated rectifier circuit (701) comprises a first pair of capacitor-isolated switches (S3, S6) selectively activated based on said polarity determined at the polarity comparator to provide the input differential voltage signal as the rectified input differential voltage signal and a second pair of capacitor-isolated switches (S4, S5) selectively activated based on said polarity determined at the polarity comparator to invert the input differential voltage signal and to provide the inverted input differential voltage signal as the rectified input differential voltage signal.

2. The bipolar input sampling network (700) of Claim 1, wherein each pair of the capacitor-isolated switches (S3, S4, S5, S6) comprises a capacitively coupled charge pump (711a, 711b, 711c, 711 d) and a transistor.

3. The bipolar input sampling network (700) of Claim 1, wherein the polarity comparator (703) is configured to determine the polarity of the input differential voltage signal based on a polarity of the sampled differential voltage signal.

4. The bipolar input sampling network (700) of Claim 1, wherein the polarity comparator (703) is configured to change a configuration of one or more circuits receiving the rectified input differential voltage signal to compensate for the polarity in the input differential voltage signal, as determined by the polarity comparator (703).

5. The bipolar input sampling network (700) of Claim 1, wherein the capacitor-isolated input sampling network comprises a first pair of capacitor-isolated switches (S1a, S2a) for providing the rectified input differential voltage signal as the sampled differential voltage signal and a second pair of capacitor-isolated switches (S1b, S2b) for inverting the rectified input differential voltage signal and providing the inverted rectified input differential voltage signal as the sampled differential voltage signal, wherein the first pair of capacitor-isolated switches (S1a, S2a) is controlled by a first control signal and the second pair of capacitor-isolated control switches (S1b, S2b) is controlled by a second control signal.

6. The bipolar input sampling network (700) of Claim 5, wherein the first control signal and the second control signal have complementary, non-overlapping waveforms.

7. The bipolar input sampling network (700) of Claim 6 being configured to, when the input differential voltage signal is determined to be negative, exchange phases of the first and second control signals.

8. The bipolar input sampling network (700) of Claim 5, wherein each capacitor-isolated switch comprises a capacitively coupled charge pump and a transistor.

9. A method for providing a bipolar input sampling network (700) that receives an input differential voltage signal (Vin) and that provides a sampled differential voltage signal, comprising:
determining a polarity of the input differential voltage signal;
providing a rectified input differential voltage signal based on the polarity determined; and
in a capacitor-isolated input sampling network (400, 704), receiving the rectified input differential voltage signal and providing the sampled differential voltage signal,
wherein
the capacitor-isolated rectifier circuit provides, through a first pair of isolated switches (S3, S6) selectively activated based on the determined polarity, the input differential voltage signal as the rectified input differential voltage signal, when the input differential voltage signal is determined to be positive, and provides, through a second pair of capacitor-isolated switches (S4, S5) selectively activated based on the determined polarity, an inverted input differential voltage signal as the rectified input differential voltage signal, when the input differential voltage signal is determined to be negative.

10. The method of Claim 9, wherein each pair of capacitor-isolated switches (S3, S4, S5, S6) comprises a capacitively coupled charge pump (711a, 711b, 711c, 711d) and a transistor.

11. The method of Claim 9, wherein the polarity of the input differential voltage signal is determined based on a polarity of the sampled differential voltage signal.

12. The method of Claim 9, further comprising changing a configuration of one or more circuits receiving the rectified input differential voltage signal based on the polarity of the input differential voltage signal determined.

13. The method of Claim 9, wherein the capacitor-isolated input sampling network comprises a first pair of capacitor-isolated switches (S1a, S2a) for providing the rectified input differential voltage signal as the sampled differential voltage signal and a second pair of capacitor-isolated switches (S1b, S2b) for inverting the rectified input differential voltage signal and providing the inverted rectified input differential voltage signal as the sampled differential voltage signal, wherein the first pair of capacitor-isolated switches (S1a, S2a) is controlled by a first control signal and the second pair of capacitor-isolated control switches (S1b, S2b) is controlled by a second control signal.

14. The method of Claim 13, wherein the first control signal and the second control signal have complementary, non-overlapping waveforms; and
wherein optionally the method further comprises, when the input differential voltage signal is determined to be negative, exchanging phases of the first and second control signals.

15. The method of Claim 13, wherein each capacitor-isolated switch comprises a capacitively coupled charge pump and a transistor.

## Patentansprüche

1. Bipolares Eingangsabtastnetzwerk (700), ausgestaltet, ein Eingangsdifferenzspannungssignal (Vin) zu empfangen, und ausgestaltet, ein abgetastetes Differenzspannungssignal bereitzustellen, umfassend:
einen Polaritätskomparator (703), der ausgestaltet ist, eine Polarität des Eingangsdifferenzspannungssignals (Vin) zu bestimmen;
eine kondensatorisolierte Gleichrichterschaltung (701), ausgestaltet, ein gleichgerichtetes Eingangsdifferenzspannungssignal basierend auf der im Polaritätskomparator bestimmten Polarität bereitzustellen; und
ein kondensatorisoliertes Eingangsabtastnetzwerk (400, 704), ausgestaltet, das gleichgerichtete Eingangsdifferenzspannungssignal zu empfangen, um das abgetastete Differenzspannungssignal bereitzustellen, wobei
die kondensatorisolierte Gleichrichterschaltung (701) ein erstes Paar von kondensatorisolierten Schaltern (S3, S6) umfasst, die basierend auf der am Polaritätskomparator bestimmten Polarität selektiv aktiviert werden, um das Eingangsdifferenzspannungssignal als das gleichgerichtete Eingangsdifferenzspannungssignal bereitzustellen, und ein zweites Paar von kondensatorisolierten Schaltern (S4, S5), die basierend auf der am Polaritätskomparator bestimmten Polarität selektiv aktiviert werden, um das Eingangsdifferenzspannungssignal zu invertieren und das invertierte Eingangsdifferenzspannungssignal als das gleichgerichtete Eingangsdifferenzspannungssignal bereitzustellen.

2. Bipolares Eingangsabtastnetzwerk (700) nach Anspruch 1, wobei jedes Paar der kondensatorisolierten Schalter (S3, S4, S5, S6) eine kapazitiv gekoppelte Ladepumpe (711a, 711b, 711c, 711d) und einen Transistor umfasst.

3. Bipolares Eingangsabtastnetzwerk (700) nach Anspruch 1, wobei der Polaritätskomparator (703) ausgestaltet ist, die Polarität des Eingangsdifferenzspannungssignals basierend auf einer Polarität des abgetasteten Differenzspannungssignals zu bestimmen.

4. Bipolares Eingangsabtastnetzwerk (700) nach Anspruch 1, wobei der Polaritätskomparator (703) ausgestaltet ist, eine Konfiguration von einer oder mehreren Schaltungen zu ändern, die das gleichgerichtete Eingangsdifferenzspannungssignal empfangen, um die Polarität im Eingangsdifferenzspannungssignal, wie vom Polaritätskomparator (703) bestimmt, zu kompensieren.

5. Bipolares Eingangsabtastnetzwerk (700) nach Anspruch 1, wobei das kondensatorisolierte Eingangsabtastnetzwerk ein erstes Paar von kondensatorisolierten Schaltern (S1a, S2a) zum Bereitstellen des gleichgerichteten Eingangsdifferenzspannungssignals als das abgetastete Differenzspannungssignal und ein zweites Paar von kondensatorisolierten Schaltern (S1b, S2b) zum Invertieren des gleichgerichteten Eingangsdifferenzspannungssignals und Bereitstellen des invertierten gleichgerichteten Eingangsdifferenzspannungssignals als das abgetastete Differenzspannungssignal umfasst, wobei das erste Paar von kondensatorisolierten Schaltern (S1a, S2a) durch ein erstes Steuer- bzw. Regelsignal gesteuert bzw. geregelt wird und das zweite Paar von kondensatorisolierten Steuer- bzw. Regelschaltern (S1b, S2b) durch ein zweites Steuer- bzw. Regelsignal gesteuert bzw. geregelt wird.

6. Bipolares Eingangsabtastnetzwerk (700) nach Anspruch 5, wobei das erste Steuer- bzw. Regelsignal und das zweite Steuer- bzw. Regelsignal komplementäre, nicht überlappende Wellenformen aufweisen.

7. Bipolares Eingangsabtastnetzwerk (700) nach Anspruch 6, das ausgestaltet ist, wenn bestimmt wird, dass das Eingangsdifferenzspannungssignal negativ ist, die Phasen des ersten und zweiten Steuer- bzw. Regelsignals zu tauschen.

8. Bipolares Eingangsabtastnetzwerk (700) nach Anspruch 5, wobei jeder kondensatorisolierte Schalter eine kapazitiv gekoppelte Ladepumpe und einen Transistor umfasst.

9. Verfahren zum Bereitstellen eines bipolaren Eingangsabtastnetzwerks (700), das ein Eingangsdifferenzspannungssignal (Vin) empfängt und ein abgetastetes Differenzspannungssignal bereitstellt, umfassend:
Bestimmen einer Polarität des Eingangsdifferenzspannungssignals;
Bereitstellen eines gleichgerichteten Eingangsdifferenzspannungssignals basierend auf der bestimmten Polarität; und
in einem kondensatorisolierten Eingangsabtastnetzwerk (400, 704) Empfangen des gleichgerichteten Eingangsdifferenzspannungssignals und Bereitstellen des abgetasteten Differenzspannungssignals, wobei
die kondensatorisolierte Gleichrichterschaltung mittels eines ersten Paares von isolierten Schaltern (S3, S6), die basierend auf der bestimmten Polarität selektiv aktiviert werden, das Eingangsdifferenzspannungssignal als das gleichgerichtete Eingangsdifferenzspannungssignal bereitstellt, wenn bestimmt wird, dass das Eingangsdifferenzspannungssignal positiv ist, und über ein zweites Paar von kondensatorisolierten Schaltern (S4, S5), die basierend auf der bestimmten Polarität selektiv aktiviert werden, ein invertiertes Eingangsdifferenzspannungssignal als das gleichgerichtete Eingangsdifferenzspannungssignal bereitstellt, wenn bestimmt wird, dass das Eingangsdifferenzspannungssignal negativ ist.

10. Verfahren nach Anspruch 9, wobei jedes Paar von kondensatorisolierten Schaltern (S3, S4, S5, S6) eine kapazitiv gekoppelte Ladepumpe (711a, 711b, 711c, 711d) und einen Transistor umfasst.

11. Verfahren nach Anspruch 9, wobei die Polarität des Eingangsdifferenzspannungssignals basierend auf einer Polarität des abgetasteten Differenzspannungssignals bestimmt wird.

12. Verfahren nach Anspruch 9, überdies umfassend das Ändern einer Konfiguration von einer oder mehreren Schaltungen, die das gleichgerichtete Eingangsdifferenzspannungssignal basierend auf der bestimmten Polarität des Eingangsdifferenzspannungssignals empfangen.

13. Verfahren nach Anspruch 9, wobei das kondensatorisolierte Eingangsabtastnetzwerk ein erstes Paar von kondensatorisolierten Schaltern (S1a, S2a) zum Bereitstellen des gleichgerichteten Eingangsdifferenzspannungssignals als das abgetastete Differenzspannungssignal und ein zweites Paar von kondensatorisolierten Schaltern (S1b, S2b) zum Invertieren des gleichgerichteten Eingangsdifferenzspannungssignals und Bereitstellen des invertierten gleichgerichteten Eingangsdifferenzspannungssignals als das abgetastete Differenzspannungssignal umfasst, wobei das erste Paar von kondensatorisolierten Schaltern (S1a, S2a) durch ein erstes Steuer- bzw. Regelsignal gesteuert bzw. geregelt wird und das zweite Paar von kondensatorisolierten Steuer- bzw. Regelschaltern (S1b, S2b) durch ein zweites Steuer- bzw. Regelsignal gesteuert bzw. geregelt wird.

14. Verfahren nach Anspruch 13, wobei das erste Steuer- bzw. Regelsignal und das zweite Steuer- bzw. Regelsignal komplementäre, nicht überlappende Wellenformen aufweisen; und
wobei das Verfahren optional überdies, wenn bestimmt wird, dass das Eingangsdifferenzspannungssignal negativ ist, das Tauschen der Phasen des ersten und zweiten Steuer- bzw. Regelsignals umfasst.

15. Verfahren nach Anspruch 13, wobei jeder kondensatorisolierte Schalter eine kapazitiv gekoppelte Ladepumpe und einen Transistor umfasst.

## Revendications

1. Réseau d'échantillonnage d'entrée bipolaire (700) configuré pour recevoir un signal de tension différentielle d'entrée (Vin) et configuré pour fournir un signal de tension différentielle échantillonné, comportant :
un comparateur de polarité (703) qui est configuré pour déterminer une polarité du signal de tension différentielle d'entrée (Vin) ;
un circuit redresseur à condensateur isolé (701) configuré pour fournir un signal de tension différentielle d'entrée redressé sur la base de la polarité déterminée au niveau du comparateur de polarité ; et
un réseau d'échantillonnage d'entrée à condensateur isolé (400, 704) configuré pour recevoir le signal de tension différentielle d'entrée redressé afin de fournir le signal de tension différentielle échantillonné, dans lequel
le circuit redresseur à condensateur isolé (701) comporte une première paire de commutateurs à condensateur isolé (S3, S6) activés sélectivement sur la base de ladite polarité déterminée au niveau du comparateur de polarité afin de fournir le signal de tension différentielle d'entrée en tant que signal de tension différentielle d'entrée redressé et une seconde paire de commutateurs à condensateur isolé (S4, S5) activés sélectivement sur la base de ladite polarité déterminée au niveau du comparateur de polarité afin d'inverser le signal de tension différentielle d'entrée et de fournir le signal de tension différentielle d'entrée inversé en tant que signal de tension différentielle d'entrée redressé.

2. Réseau d'échantillonnage d'entrée bipolaire (700) selon la revendication 1, dans lequel chaque paire des commutateurs à condensateur isolé (S3, S4, S5, S6) comporte une pompe de charge couplée de façon capacitive (711 a, 711b, 711c, 711d) et un transistor.

3. Réseau d'échantillonnage d'entrée bipolaire (700) selon la revendication 1, dans lequel le comparateur de polarité (703) est configuré pour déterminer la polarité du signal de tension différentielle d'entrée sur la base d'une polarité du signal de tension différentielle échantillonné.

4. Réseau d'échantillonnage d'entrée bipolaire (700) selon la revendication 1, dans lequel le comparateur de polarité (703) est configuré pour modifier une configuration d'un ou de plusieurs circuits recevant le signal de tension différentielle d'entrée redressé afin de compenser la polarité dans le signal de tension différentielle d'entrée, tel que déterminé par le comparateur de polarité (703).

5. Réseau d'échantillonnage d'entrée bipolaire (700) selon la revendication 1, dans lequel le réseau d'échantillonnage d'entrée à condensateur isolé comporte une première paire de commutateurs à condensateur isolé (S1a, S2a) pour fournir le signal de tension différentielle d'entrée redressé en tant que signal de tension différentielle échantillonné et une seconde paire de commutateurs à condensateur isolé (S1b, S2b) pour inverser le signal de tension différentielle d'entrée redressé et fournir le signal de tension différentielle d'entrée redressé inversé en tant que signal de tension différentielle échantillonné, dans lequel la première paire de commutateurs à condensateur isolé (S1a, S2a) est commandée par un premier signal de commande et la seconde paire de commutateurs de commande à condensateur isolé (S1b, S2b) est commandée par un second signal de commande.

6. Réseau d'échantillonnage d'entrée bipolaire (700) selon la revendication 5, dans lequel le premier signal de commande et le second signal de commande ont des formes d'onde complémentaires et non chevauchantes.

7. Réseau d'échantillonnage d'entrée bipolaire (700) selon la revendication 6, configuré pour, lorsque le signal de tension différentielle d'entrée est déterminé comme étant négatif, échanger des phases des premier et second signaux de commande.

8. Réseau d'échantillonnage d'entrée bipolaire (700) selon la revendication 5, dans lequel chaque commutateur à condensateur isolé comporte une pompe de charge couplée de façon capacitive et un transistor.

9. Procédé pour fournir un réseau d'échantillonnage d'entrée bipolaire (700) qui reçoit un signal de tension différentielle d'entrée (Vin) et qui fournit un signal de tension différentielle échantillonné, comportant :
la détermination d'une polarité du signal de tension différentielle d'entrée ;
la fourniture d'un signal de tension différentielle d'entrée redressé sur la base de la polarité déterminée ; et
dans un réseau d'échantillonnage d'entrée à condensateur isolé (400, 704), la réception du signal de tension différentielle d'entrée redressé et la fourniture du signal de tension différentielle échantillonné, dans lequel
le circuit redresseur à condensateur isolé fournit, à travers une première paire de commutateurs isolés (S3, S6) activés sélectivement sur la base de la polarité déterminée, le signal de tension différentielle d'entrée en tant que signal de tension différentielle d'entrée redressé, lorsque le signal de tension différentielle d'entrée est déterminé comme étant positif, et fournit, à travers une seconde paire de commutateurs à condensateur isolé (S4, S5) activés sélectivement sur la base de la polarité déterminée, un signal de tension différentielle d'entrée inversé en tant que signal de tension différentielle d'entrée redressé, lorsque le signal de tension différentielle d'entrée est déterminé comme étant négatif.

10. Procédé selon la revendication 9, dans lequel chaque paire de commutateurs à condensateur isolé (S3, S4, S5, S6) comporte une pompe de charge couplée de façon capacitive (711a, 711b, 711c, 711d) et un transistor.

11. Procédé selon la revendication 9, dans lequel la polarité du signal de tension différentielle d'entrée est déterminée sur la base d'une polarité du signal de tension différentielle échantillonné.

12. Procédé selon la revendication 9, comportant en outre le changement d'une configuration d'un ou de plusieurs circuits recevant le signal de tension différentielle d'entrée redressé sur la base de la polarité du signal de tension différentielle d'entrée déterminé.

13. Procédé selon la revendication 9, dans lequel le réseau d'échantillonnage d'entrée à condensateur isolé comporte une première paire de commutateurs à condensateur isolé (S1a, S2a) pour fournir le signal de tension différentielle d'entrée redressé en tant que signal de tension différentielle échantillonné et une seconde paire de commutateurs à condensateur isolé (S1b, S2b) pour inverser le signal de tension différentielle d'entrée redressé et fournir le signal de tension différentielle d'entrée redressé inversé en tant que signal de tension différentielle échantillonné, dans lequel la première paire de commutateurs à condensateur isolé (S1a, S2a) est commandée par un premier signal de commande et la seconde paire de commutateurs de commande à condensateur isolé (S1b, S2b) est commandée par un second signal de commande.

14. Procédé selon la revendication 13, dans lequel le premier signal de commande et le second signal de commande ont des formes d'onde complémentaires et non chevauchantes ; et
dans lequel, de manière facultative, le procédé comporte en outre, lorsque le signal de tension différentielle d'entrée est déterminé comme étant négatif, l'échange de phases des premier et second signaux de commande.

15. Procédé selon la revendication 13, dans lequel chaque commutateur à condensateur isolé comporte une pompe de charge couplée de manière capacitive et un transistor.
